Europäisches Patentamt

(19) European Patent Office

Office européen des brevets

(11) Numéro de publication: **0 038 294**
**B1**

(12) **FASCICULE DE BREVET EUROPEEN**

(45) Date de publication du fascicule du brevet: **27.12.84**

(51) Int. Cl.³: **C 23 C 15/00**, G 04 B 37/22

(21) Numéro de dépôt: **81810105.7**

(22) Date de dépôt: **18.03.81**

(54) **Procédé de dépôt d'un revêtement dur métallique, cible de dépôt pour un tel procédé et pièce de joaillerie comportant un tel revêtement.**

(30) Priorité: **10.04.80 CH 2750/80**

(43) Date de publication de la demande:
**21.10.81 Bulletin 81/42**

(45) Mention de la délivrance du brevet:
**27.12.84 Bulletin 84/52**

(84) Etats contractants désignés:
**AT BE CH DE FR IT LI NL SE**

(56) Documents cités:
**CH-A-1 784 372
CH-B- 563 031
FR-A-2 110 202
FR-A-2 234 144
FR-A-2 282 483
FR-A-2 412 619
GB-A-1 427 674
GB-A-2 000 812
US-A-3 857 682
US-A-3 912 461**

(73) Titulaire: **ETA S.A., Fabriques d'Ebauches
Schild-Rust-Strasse 17
CH-2540 Granges (CH)**

(72) Inventeur: **Bergmann, Erich
rue des Bains 26
CH-2500 Bienne (CH)**

(74) Mandataire: **Schneider, Jürg et al
c/o ASUAG Faubourg du Lac 6
CH-2501 Bienne (CH)**

(56) Documents cités:
**THIN SOLID FILMS, vol. 54, no. 1, octobre 1978,
Elsevier Sequoia, LAUSANNE (CH) R.F.
BUNSHAH et al.: "Structure and properties of
refractory compounds deposited by electron
beam evaporation", pages 85-106**

Courier Press, Leamington Spa, England.

## Description

Les procédés de dépôt d'un revêtement dur métallique ont fait l'objet de nombreux travaux en particulier dans le domaine de la fabrication des boîtes de montres pour lesquelles le but recherché consiste à obtenir pour un substrat massif et dur, présentant une bonne résistance au rayage, l'aspect et l'éclat de l'or ou de métal noble mais rayable. Différents procédés ont été utilisés. Le plus souvent ces procédés consistent à effectuer, sur le substrat massif, le dépôt d'une couche d'un composé d'azote et d'un métal du groupe IV de la classification périodique des éléments ou d'un mélange de ces composés. Un tel procédé a été décrit dans la demande de brevet suisse no 2962/74 dans laquelle, par un procédé d'évaporation sous vide de telles substances, le dépôt de couches dures permet de fabriquer des pièces présentant une grande résistance aux chocs contre objets acérés et des couleurs inaltérables. Un tel procédé ne permet cependant pas d'obtenir, pour le revêtement, l'aspect incomparable de l'or.

Un autre procédé décrit dans la demande de brevet allemand DOS 27 05 225 consiste à effectuer un revêtement essentiellement constitué de nitrure de titane TiN composé bien connu pour sa couleur jaune évoquant celle du métal noble. Un tel procédé ne permet cependant pas d'obtenir l'éclat incomparable de l'or indispensable aux pièces de joaillerie de qualité.

Un autre procédé encore décrit dans la demande de brevet britannique No 2 000 812A consiste à déposer sur une première couche de TiN, TaN, TaC, ZrN ou Vn une couche de métal noble ou d'alliage soit par évaporation et placage ionique (exemples 1 et 2), soit par un placage électrochimique suivi d'un traitement thermique de diffusion (exemples 3 et 5). Il est également envisagé de réaliser successivement des couches de Ti, de TiN, d'un mélange de TiN et de métal noble, et d'or ou d'un alliage d'or. Les revêtements obtenus dans tous ces modes de réalisation sont constitués de couches superposées de compositions très différentes, déposées l'une après l'autre. Ils risquent par conséquent de présenter des défauts d'homogénéité ou de résistance au rayage ou aux chocs thermiques aux interfaces entre les différentes couches.

Il est également prévu dans la même demande de brevet britannique (exemple 4) de former, après le dépôt par évaporation et placage ionique d'une couche de TiN, une deuxième couche obtenue par l'évaporation simultanée de deux cibles distinctes formées respectivement de Ti et de Cu. Les remarques précédentes s'appliquent encore, mais, en outre, on notera que ce procédé ne permet pas d'obtenir une couche de métal noble à la surface externe du revêtement, et qu'il doit être difficile de réaliser des dépôts uniformes sur des substrats à partir de deux cibles distinctes, dont l'une est par ailleurs vaporisée par un faisceau électronique, l'autre l'étant par chauffage par résistance, le tout en atmosphère réactive.

C'est pourquoi l'un des objects de l'invention est de proposer un procédé simple, permettant d'effectuer des dépôts de revêtements durs métalliques dont la composition varie de façon progressive du substrat vers la surface extérieure, et cela au moyen d'une cible soumise à un seul processus d'évaporation ou de pulvérisation.

L'invention propose également un cermet particulièrement bien adapté à l'usage de cible pour ce procédé, ainsi qu'une pièce de joaillerie obtenue par ce procédé.

Le procédé de l'invention, le cermet et la pièce de joaillerie susmentionnés sont définis dans les revendications.

L'invention sera mieux comprise à l'aide de la description et des dessins ci-après où les mêmes références représentent les mêmes éléments et où les proportions des cotes et dimensions n'ont pas été respectées afin d'assurer une meilleure compréhension de l'ensemble dans lesquels

la figure 1 représente un schéma illustrant le procédé selon l'invention,

la figure 2 représente une variante de réalisation du procédé selon l'invention,

la figure 3 représente un procédé de réalisation de la cible des figures 4a et 4b ou 5a et 5b,

les figures 4a et 4b représentent une cible pour la mise en oeuvre du procédé de l'invention,

les figures 5a et 5b représentent une variante de réalisation de la cible des figures 4a et 4b,

les figures 6a, 6b représentent une autre variante de réalisation du procédé selon l'invention,

les figures 7a et 7b représentent un autre exemple non limitatif de mise en oeuvre du procédé selon l'invention,

les figures 8a et 8b représentent un autre exemple de mise en oeuvre du procédé selon l'invention,

les figures 9a et 9b représentent une pièce de joaillerie obtenue par la mise en oeuvre du procédé selon l'invention.

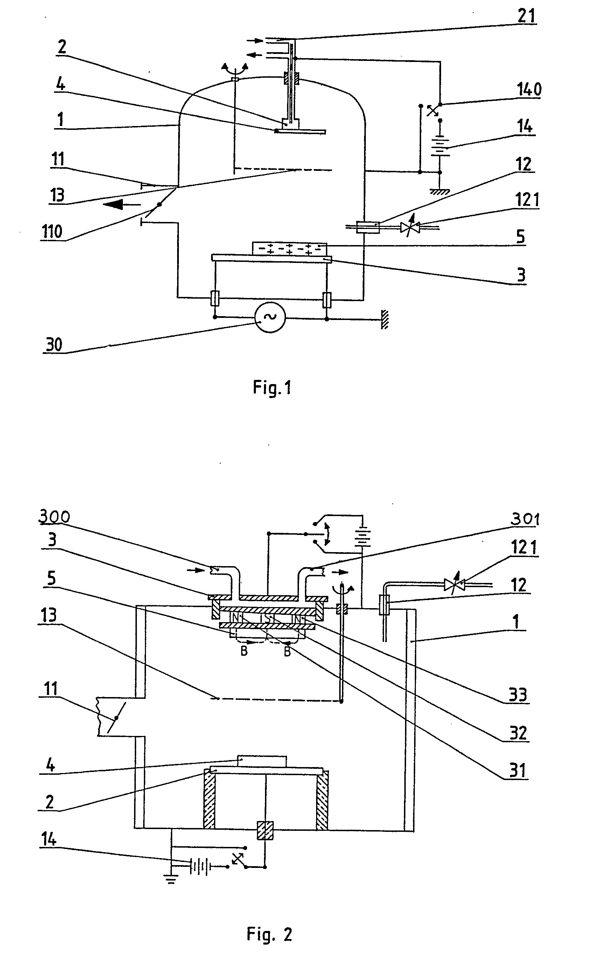

Selon la figure 1, le procédé de dépôt d'un revêtement métallique conformément à l'invention dans le cas d'un composé d'or consiste à effectuer les opérations suivantes. Dans une enceinte à vide 1, comportant au moins deux électrodes 2 et 3 le substrat 4 est fixé sur l'électrode 2 dite électrode de substrat. L'électrode de substrat 2 est refroidie par un dispositif de circulation d'eau 21, par exemple, lequel permet également l'évacuation de la chaleur emmagasinée par le substrat au cours du dépôt. Une cible de dépôt 5 est placée sur l'électrode 3 dite électrode de cible. Comme on le verra plus en détail dans ce qui suit, la cible 5 est constituée d'or et d'au moins un des

composés métalliques tels que nitrure, carbure, borure des métaux du groupe 4A de la classification périodique des éléments et du tantale, ces éléments étant répartis dans la cible de façon particulière. L'or est de préférence de l'or pur ou de l'or de titre supérieur à 18 carats.

Une atmosphère d'argon de grande pureté est établie dans l'enceinte à vide. A cet effet l'enceinte à vide est mise en communication avec une pompe turbomoléculaire non représentée à la figure 1 par une ouverture 11 permettant d'effectuer un vide dans l'enceinte a à $10^{-6}$ Torr. Un pression d'argon ou d'un gaz inerte quelconque comprise entre $4 \times 10^{-4}$ et $3 \times 10^{-2}$ Torr est établie alors dans l'enceinte à vide 1 par l'intermédiaire d'une buse d'injection 12 munie d'une vanne de précision 121 et par fermeture partielle de la vanne d'étranglement 110.

Un décapage ionique du substrat 4 est effectué par érosion ionique. A cet effet l'enceinte à vide 1 est reliée au potentiel de référence du dispositif et munie d'un écran mobile 13 relié à ce même potentiel de référence et placé en vis-à-vis du substrat 4 pendant l'opération de décapage. Un système de polarisation 14 muni d'un interrupteur 140 permet de porter l'électrode de substrat et le substrat à un potentiel négatif de l'ordre de 1 KV pendant quelques minutes afin d'assurer, si nécessaire, le décapage du substrat. L'écran mobile 13 est alors retiré. Le dépôt sur le substrat 4 à partir de la cible de dépôt 5 est alors effectué à vitesse de dépôt déterminée selon la nature du substrat (boîtier de montre, article de Paris, ou pièce de joaillerie). La vitesse de dépôt peut êntre comprise entre 0,1 et 10 $\mu$m par minute selon le substrat à revêtir.

Ce substrat est un substrat massif métallique ou en matériau fritté. Le dépôt peut être effectué, conformément au procédé selon l'invention, soit par dépôt ionique, par exemple par pulvérisation cathodique, soit par évaporation.

L'invention sera maintenant décrite en nelation avec la figure 2 dans le cas de la pulvérisation cathodique effectuée à l'aide d'une enceinte à vide comportant un magnétron plat. L'enceinte à vide comporte au moins une anode, en général la paroi de l'enceinte à vide 1, dont le potentiel est pris comme potentiel de référence, une électrode de substrat 2 et une électrode de cible 3 constituant la cathode du magnétron. Ce magnétron plat est représenté sur la figure 2 par sa cathode comportant un circuit de refroidissement par eau 300, 301 et par les aimants permanents 31, 32, 33 créant un champ magnétique B parallèle à l'électrode de cible 3. Le procédé selon l'invention consiste à fixer le substrat à revêtir 4 sur l'électrode de substrat 2, la cible 5 dont la structure particulière sera décrite ci-après et constituée essentiellement en pourcentage volumique identique de nitrures, carbures, borures métalliques et d'or étant fixée sur l'électrode de cible 3 constituant la cathode du magnétron. Une atmosphère neutre d'argon pur ou réactive, mélange argon azote, à pression comprise entre $1 \times 10^{-2}$ et $5 \times 10^{-2}$ Torr est établie dans l'enceinte 1. Un décapage par érosion ionique du substrat est effectué si nécessaire, l'électrode de substrat 2 étant portée, par exemple, à un potentiel négatif de l'ordre de 1,5 KV par rapport à la tension de référence par le circuit de polarisation 14 et l'écran 13, relié à ce potentiel de référence, étant interposé dans l'espace situé entre les électrodes de substrat et de cible. L'espace inter électrode bien que non représenté fidèlement selon les proportions de la figure 2 est de l'ordre d'une dizaine de centimètres. Ensuite la pression est baissée entre $4 \times 10^{-4}$ et $2 \times 10^{-2}$ Torr et l'électrode de cible 2 est par exemple portée à un potentiel négatif (de l'ordre de quelques centaines de volts), inférieur en valeur absolue à la tension de l'électrode de substrat de manière que le courant de substrat soit inférieur au courant de cible selon le procédé habituel de pulvérisation cathodique, l'écran étant retire. De ce fait de dépôt d'ions provenant de la cible est effectué sur le substrat.

Selon une caractéristique non limitative de l'invention, la cible composite est constituée essentiellement d'or et d'un mélange de nitrures, carbures, borures métalliques, l'or et le mélange étant sensiblement en pourcentage volumique identique.

A titre d'exemple, pour une cible comportant en volume 50% d'or et 50% de mélange, le mélange comporte du nitrure de titane TiN et du carbure de titane TiC. Le carbure de titane TiC de couleur gris clair permet notamment d'obtenir une teinte or plus claire, le pourcentage en volume de ce constituant permettant d'obtenir différentes nuances de la teinte or. Le pourcentage en volume de carbure de titane n'excédera cependant pas 30% afin de conserver au revêtement sa teinte dorée. Le carbure de titane joue alors un rôle analogue à celui de l'argent métal dans les alliages d'orfèvrerie courants.

Afin d'obtenir une dureté plus grande du revêtement, le carbure de titane TiC peut également être remplacé par du borure de titane $TiB_2$, également de couleur grise et de dureté supérieure, ou par un mélange $TiC + TiB_2$, la concentration de ce mélange ou du borure de titane $TiB_2$ seul n'excédant pas 10% en volume.

Dans le but d'obtenir une teinte or plus pâle, le nitrure de titane TiN peut également être remplacé par un mélange de nitrure de titane TiN et de carbure de tantale TaC le rapport de concentration volumique entre le nitrure de titane et le carbure de tantale n'excédant pas 4 soit

$$\frac{TiN\%}{TaC\%} \leqslant 4.$$

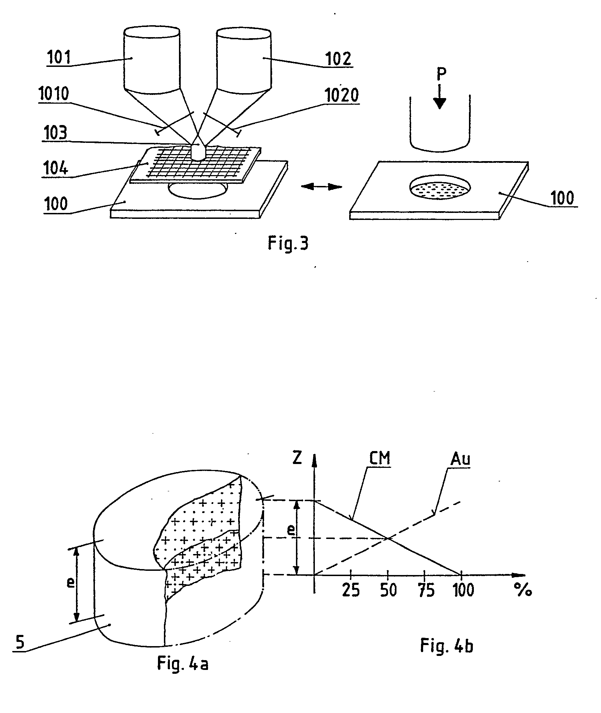

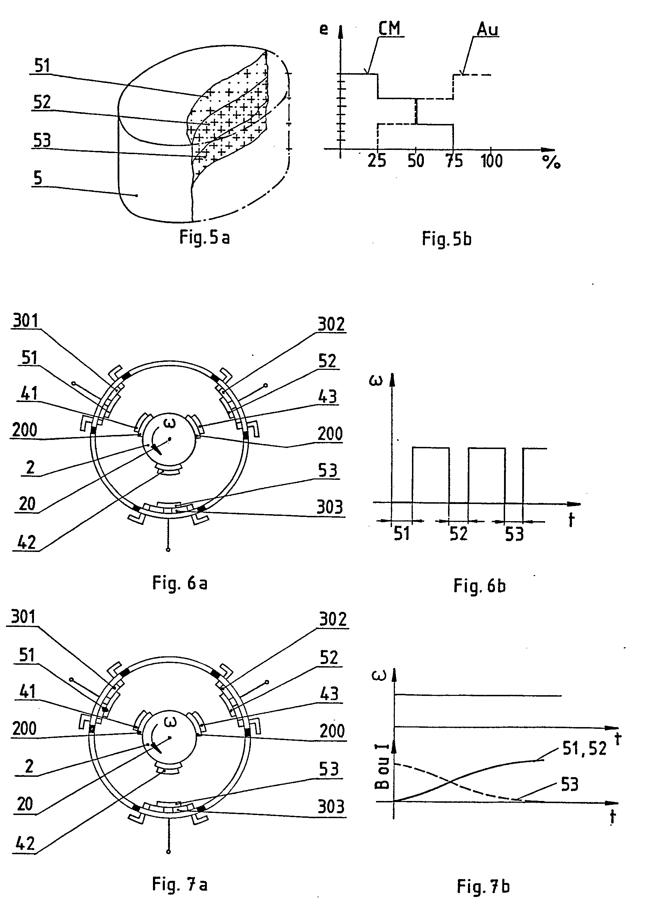

Ainsi que représenté aux figures 4a et 5a, la cible est une pastille ou plaquette contenant de l'or et au moins un composé métallique noté CM des métaux du groupe 4A de la classification périodique des éléments et du tantale. La pastille ou plaquette 5 est obtenue par exemple par tout procédé métallurgique connu. En particulier, ainsi que décrit dans le brevet suisse no 532 125, le procédé de frittage des poudres d'or et de nitrure metallique étant généralement difficile à mettre en oeuvre, la cible 5 est constituée par une ébauche de compact réalisée à partir de poudre de nitrure, carbure, borure métallique et d'or, la cible composite constituant de cette manière un cermet.

A titre d'exemple avantageux de préparation d'un tel cermet, ainsi que représenté à la figure 3, un mélange de poudre d'or et de poudre de nitrures, carbures ou borures métalliques, par exemple du nitrure de titane TiN, en pourcentage volumique identique est effectué. A titre d'exemple non limitatif, pour une cible de masse totale voisine de 25 grammes le mélange comprend 19,33 g de poudre d'or et 5,22 g de nitrure de titane. Le mélange de poudre est versé dans un moule à compactage 100 et ensuite pressé à température ambiante à une pression P comprise entre 0,1 et 0,5 tonne par cm² de façon à obtenir une ébauche de compact d'épaisseur finale pouvant être comprise entre 100 $\mu$m et 2 à 3 mm. L'ébauche de compact ainsi obtenue constitue un exemple de réalisation de la cible composite.

Selon un autre exemple une cible de masse totale voisine de 25 grammes de mélange comprend 19,33 g de poudre d'or 4,2 g de poudre de nitrure de titane et 1,9 g de poudre de carbure de tantale. Le nitrure de titane TiN peut également, dans cet exemple, être avantageusement remplacé, pour l'obtention de propriétés mécaniques analogues du revêtement, par un mélange de 4,2 g de nitrure de titane, 0,3 g de borure de titane et de 0,3 g de carbure de titane, ce mélange constituant le composé CM. Le mélange de poudre d'or et de poudre de nitrure, corbure, borure métallique est obtenu au moyen du dispositif représenté à la figure 3, dans lequel un ensemble de deux ou plusieurs trémies 101, 102 comportant chacune une vanne de débit 1010, 1020, réglable en fonction de la granulométrie de la poudre emmagasinée dans chaque trémie ainsi que de la structure particuliére souhaitée pour le cermet alimente une goulotte mélangeuse 103 débitant elle-même le mélange sur un tamis vibrant 104. Chacune des trémies étant chargée avec une poudre de nature déterminée ou d'un mélange préétabli de ces poudres, or ou nitrures, borures, carbures, métalliques, tel que TiC, TiN, TaN, HfN, ZrN, le tamis vibrant délivre un mélange homogène. De tels systèmes de trémies sont disponibles dans le commerce sous le nom commercial "Metco type 3MP Plasma Powder Feed Unit".

La figure 4a représente un mode de réalisation particulier de la cible composite permettant la mise en oeuvre du procédé selon l'invention. Conformément à la figure 4a, la cible composite 5 constituée par un cermet comporte suivant son épaisseur e des gradients de concentration en volume de composé métallique CM et d'or opposés. La cote 0 de l'épaisseur de la cible composite 5 représentée à la figure 4a étant définie au niveau de la base de la cible, les concentrations en pourcentage volumique d'or et de nitrure, carbure, borure, métallique en fonction de la cote z selon l'épaisseur e de la cible suivent des lois linéaires de pentes opposées comme le montre la figure 4b. Une telle cible permit pour la mist en oeuvre du procédé selon l'invention d'obtenir un revêtement de structure analogue a celle de la cible, la transition progressive entre nitrure, carbure, borure métallique et or au niveau de la cible et du revêtement déposé permettant une meilleure approximation des conditions de réflectivité, en fonction de la longueur d'onde de la lumière incidente, de l'or utilisé en orfèvrerie. La transition progressive permet également une adhérence parfaite des zones superficielles du revêtement, constituées essentiellement d'or, aux zones soud-jacentes en nitrure, carbure, borure métallique de grande dureté. Ainsi pour une cible à gradient de concentration tel que le pourcentage volumique de nitrure, carbure, borure métallique et d'or soit identique à mi-épaisseur, permettant le dépôt d'un revêtement de structure analogue à celle de la cible, ce revêtement soumis au test de dureté selon le procédé Vickers présente une dureté supérieure à 1000 Vickers.

La cible comportant un gradient de concentration peut être obtenue à l'aide de l'appareillage décrit précédemment en rapport avec la figure 3, le débit des vannes des trémies 1010, 1020 étant régulé en fonction de la cote z d'épaisseur de la cible. Dans le but d'assurer au niveau du revêtement d'épaisseur e' la conservation du gradient de cible, chaque cible, compte tenu de e' et du rendement de dépôt k, a une épaisseur e environ proportionnelle au rapport

$$\frac{1}{k}.$$

Afin de faciliter la préparation des cibles pour un revêtement donné, ainsi que représenté aux figures 5a et 5b, le gradient de concentration en volume de nitrure métallique et d'or est obtenu par superposition de couches élémentaires constituées chacune par un mélange de poudre d'or et de poudre de nitrure, carbure, borure métallique de concentration volumique respective déterminée.

L'approximation de la loi linéaire de la concentration en fonction de l'épaisseur par des échelons successifs permet une simplification de l'utilisation du dispositif représenté à la figure 3, le réglage des vannes des trémies pouvant être ramené à un nombre discret de réglages successifs simples.

A titre d'exemple ainsi que représenté de manière non limitative aux figures 5a et 5b, la cible comporte 3 couches élémentaires 51, 52, 53 symétriques par rapport à la demi-épaisseur de la cible, les couches 51, 52 et 53 comportant en volume 75% d'or, 25% de nitrure, carbure, borure métallique, 50% d'or, 50% de nitrure, carbure, borure métallique, 25% d'or, 75% de nitrure, carbure, borure métallique. Tout mode de réalisation comportant un nombre de couches et des concentrations différents et en particulier une couche superficielle, telle que la couche 51 comportant essentiellement de l'or de titre ⩾18 carats et/ou au moins un des métaux nobles précités, ne sort pas du cadre de la présente invention. En veu d'obtenir pour le revêtement l'éclat de l'or, la cible constituée par le cermet est disposée sur l'electrode de cible 3 de manière que la zone du cermet présentant la concentration en or la plus élevée se trouve en contact avec celle-ci. Le dépôt est ainsi effectué préférentiellement pour le composé métallique ou mélange de composés métalliques puis pour l'or ou métal noble successivement.

Les cibles telles que représentées aux fig. 4a et 5a sont essentiellement constituées par de l'or et par du nitrure, carbure, borure de titane en pourcentage volumique identique ou par le l'or et par un mélange de nitrures, carbures, borures métalliques. Les carbonitrures des métaux précités peuvent en outre être utilisés pour constituer les cibles.

Selon un autre exemple de réalisation de cible composite le mélange sensiblement en pourcentage volumique identique est constitué par du nitrure de titane et du nitrure de zirconium TiN, ZrN soit pour une cible de 50 grammes sensiblement,

38,66 g d'or, Au

6,96 g de TiN

4,73 g de ZrN

Selon un autre exemple de réalisation de cible le mélange de nitrure métallique est constitué sensiblement par du nitrure de titane TiN, du nitrure de zirconium ZrN et du nitrure de Hafnium HfN soit par exemple pour une cible de 50 g sensiblement.

38,66 g d'or

6,96 g de TiN

4,71 g de ZrN

0,02 g de HfN

La figure 6 a représente une variante du procédé selon l'invention tel que décrit en rapport avec la figure 2. Dans la figure 6a, l'enceinte comporte trois électrodes de cible élémentaires 301, 302, 303 constituant un dispositif à cellules multiples. L'électrode de substrat 2 est mobile en rotation autour d'un axe 20, les électrodes de cible 301, 302, 303 étant placées de révolution autour de cet axe. En fait une pluralité de plateformes porte substrat 200 peut être prévue à la périphérie de l'électrode porte substrat 2. De tels dispositifs sont couramment disponibles dans le commerce. Le substrat à revêtir 41, 42, 43, est fixé sur une des plateformes porte substrat 200. Chaque électrode de cible élémentaire 301, 302, reçoit une cible élémentaire 51, 52, les cibles élémentaires 51, 52 constituant ensemble une cible composite. A titre d'exemple non limitatif, chaque cible élémentaire 51, 52, 53 est constituée par un mélange en pourcentage volumique déterminé d'or et de composé métallique et l'ensemble des cibles élémentaires constituant une cible composite d'or et de composé métallique en pourcentage volumique identique. A cet effet chaque cible 51 est par exemple constituée par un cermet tel que décrit précédemment, comportant 75% d'or en volume et 25% de nitrures, carbures, borures métalliques, la cible 52 comporte 50% d'or et 50% de nitrures, carbures, borures métalliques et la cible 53 comporte 25% d'or et 75% de nitrures, carbures, borures métalliques en volume. Le substrat porté par exemple par la plateforme 200 est tout d'abord amené en vis-à-vis de la cible 53, puis selon une loi de mouvement $\omega$ de l'électrode de substrat, en vis-à-vis des cibles 52 et 51 successivement où une couche élémentaire d'épaisseur déterminée et de concentration correspondante est déposée selon les phases de procédé précitées permettant la reconstitution du gradient de concentration du revêtement par couches élémentaires. La vitesse de dépôt des cibles élémentaires est réglable indépendamment par le réglage du courant électrique qui alimente chaque électrode élémentaire ou par réglage du champ magnétique du magnétron parallèle à la surface du substrat à revêtir. Ainsi que représenté à la figure 6b, pour un temps d'exposition identique de chaque substrat devant une cible élémentaire donnée le courant électrique peut être réglé compte tenu de l'épaisseur de la couche élémentaire à déposer, ce qui permet de simplifier la loi de mouvement $\omega$ de l'électrode de substrat qui se réduit ainsi à un mouvement périodique uniforme.

Le présent procédé n'est pas limité à un nombre de cibles élémentaires égal à trois, ni aux concentrations et proportions relatives précitées. En particulier tout procédé dans lequel une première cible élémentaire est constituée par de l'or de titre ⩾18 carats et/ou métal noble, et au moins une autre cible, élémentaire constituée par du nitrure de titane pur TiN, ne sort pas du cadre de la présente invention.

Ainsi que représenté à la figure 7a, le magnétron plat comporte une électrode de cible comportant au moins deux électrodes élémentaires constituant un dispositif à cellule multiple. L'électrode de substrat étant entraînée à vitesse angulaire constante (fig. 7b), par exemple à une vitesse permettant une exposition du substrat devant chaque cible à une fréquence de l'ordre de 500 Hz, les conditions de vide et de décapage ionique étant préalablement effectuées, le dépôt est effectué simultanément à partir de chaque cible, élémentaire, la vitesse de dépôt pour chaque cible élémentaire étant régulée par l'intermédiare du courant électrique I ou du champ magnétique B selon une loi linéaire opposée. Chaque cible élémentaire est composée, par exemple, respectivement d'or et/ou métal noble et de composé métallique pur. Tout mode de réalisation dans lequel une inversion cinématique de la régulation est effectuée, c'est-à-dire dans lequel, par exemple, une vitesse de dépôt constante est prévue pour chaque cible élémentaire, le temps d'exposition étant modulé selon une loi linéaire en fonction de la concentration réelle de chaque couche élémentaire du revêtement, ne sort pas du cadre de la présente invention. Les vitesses de dépôt peuvent dans tous les cas être régulées par réglage du courant cathodique de chaque électrode cible élémentaire.

Selon une variante de réalisation de l'invention, le dépôt est effectué par un dépôt ionique du type plaquage ionique selon le procédé Mattox ou activé par décharges secondaires.

A cet effet, l'électrode de cible 3 ainsi que représentée sur la figure 1, normalement au potenciel de référence peut, par exemple, être chauffée par effet joule par un circuit de chauffage 30 à une température qui correspond à une pression de vapeur très supérieure à la pression du gaz dans l'enceinte. L'électrode 2 de substrat est alors, en l'absence de l'écran 13, portée à un potentiel négatif de l'ordre de 10 KV par le système de polarisation 14, potentiel qui est fonction des paramètres pression interne de l'enceinte à vide et distance substrat cible.

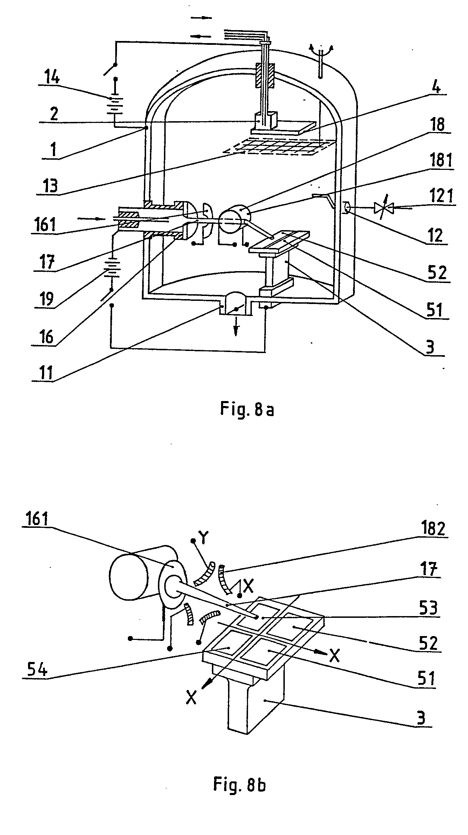

La figure 8a est relative à une variante de réalisation de l'invention, le dépôt du matériau constituant la cible étant effectué par évaporation de la cible. Dans ce cas, selon le schéma en coupe de la fig. 8a, la cible composite 5 est constituée également par au moins deux cibles élémentaires 51, 52, constituées respectivement par de l'or de titre inférieur à 18 carats et par un mélange de composé métallique. Dans la figure 8a, les mêmes références représentent les mêmes éléments que ceux relatifs à l'enceinte à vide des figures 1 ou 6. L'enceinte à vide 1 comporte en outre un canon à éléctrons 16 permettant l'émission d'un faisceau d'électrons 17. Le faisceau d'électrons 17 est focalisé sur la cible composite 51, 52 par des moyens de focalisation 18 et permet l'évaporation de la cible par bombardement électronique, la cible composite 51, 52 et l'électrode de cible 3 étant portées à un potentiel positif par rapport au canon à électrons 16 par un circuit de polarisation 19. Pour une description plus détaillée du dispositif on pourra se reporter par exemple à l'article publié par Sonyi Komiya et Kazuyuki Tsurmoka intitulé "Physical vapor deposition of thick Cr and its carbide and nitride films by hollow cathode discharge" publié dans la revue "Journal of the Vacuum Science and Technology" volume 13, no 1, janvier/février 1976.

Selon l'invention, le faisceau électronique 17 est commuté périodiquement sur chaque cible élémentaire après que les étapes précédemment décrites d'établissement d'une atmosphère d'argon pur et de décapage ionique aient été effectuées comme indiqué précédemment. Le faisceau électronique 17 est par exemple commuté á une fréquence fixe comprise entre 30 et 100 Hz. A cet effet, les moyens de focalisation 18 comportent, par exemple, un enroulement de commande 181 permettant de commuter le faisceau électronique 17 par déflexion.

Le procédé selon l'invention peut également être mis en oeuvre en atmosphère réactive, l'atmosphère d'argon pur étant remplacé par exemple par un mélange argon-azote à 50% en volume à même pression.

Afin d'assurer un meilleur rendu du gradient de concentration du revêtement, le faisceau électronique 17 est modulé en intensité par une électrode de modulation 161 disposée au voisinage du canon à électrons et à laquelle est appliquée une tension négative par rapport au canon à électrons 16. Cette électrode de modulation joue sensiblement le rôle d'une électrode de Wehnelt. Dans des conditions identiques de pression, la vitesse d'evaporation donc de déposition est fonction de l'intensité du faisceau d'électrons 17.

Selon une variante de réalisation représentée à la figure 8b, la cible composite est constituée par un arrangement de cibles élémentaires 51, 52, 53, 54. Chaque cible élémentaire est constituée par exemple respectivement par de l'or, par du titane, du hafnium et par du zirconium l'ensemble de l'enceinte à vide étant soumis à une atmosphère réactive 50% azote 50% argon ainsi qui décrit précédemment. Le faisceau électronique 17 est commuté périodiquement sur chaque cible élémentaire à une fréquence fixe comprise entre 100 et 400 Hz. Afin d'assurer une commutation plus rapide et plus précise du faisceau électronique l'enroulement 181 des moyens de focalisation est remplacé par un dispositif de déflexion 182 tel que par exemple une lentille quadrupolaire permettant la commutation en x, y, du faisceau 17. Pour une description plus détaillée du dispositif muni d'une lentille quadrupolaire on pourra se reporter à la technique habituelle du balayage du type télévision bien connu de l'homme de l'art.

Le procédé décrit et ses différentes variantes peuvent être utilisés pour l'obtention de pièces de joaillerie, l'or pouvant être remplacé par l'or blanc, l'argent, le rhodium, le palladium, le platine, l'iridium, l'osmium désignés ci-après par métaux nobles, séparément ou en combinaison.

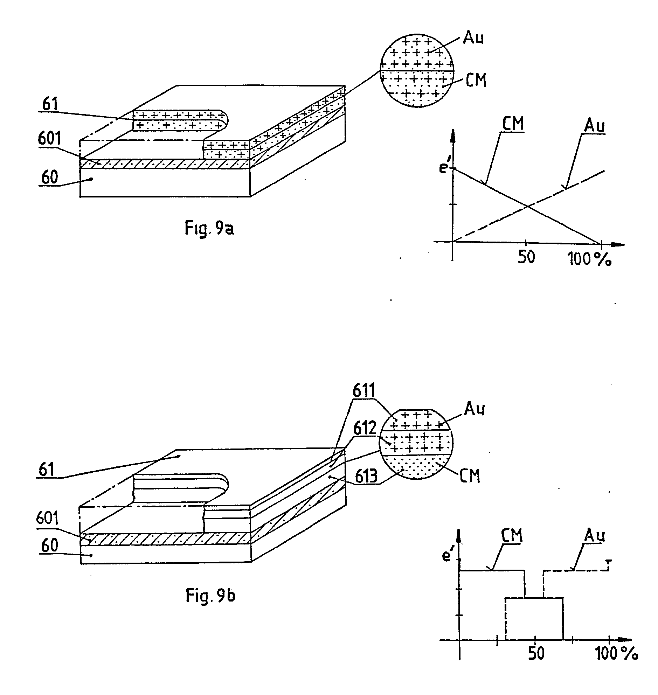

De manière générale les pièces de joaillerie ainsi obtenues comportent ainsi que représenté aux figures 9a et 9b, sur un substrat massif 60, substrat métallique bon marché, tel que par exemple du laiton, un revêtement 61 constitué essentiellement d'or Au et de composé métallique CM en pourcentage volumique identique. Afin d'augmenter la dureté de l'ensemble du revêtement, une couche intermédiaire 601 peut être disposée entre le substrat 60 et le revêtement de composé d'or. La couche intermédiaire 601 peut par exemple être déposée à partir d'une cible élémentaire conformément au procédé selon l'invention, la cible composite étant constituée soit par plusieurs autres cibles élémentaires ou par une cible composite unique ainsi que décrit précédemment conformément au procédé selon l'invention. De préférence la couche intermédiaire est constitué par de l'acier inoxydable ou par du chrome sur une épaisseur de l'ordre de 5 à 20 $\mu$m ou par du nitrure de titane TiN sur une épaisseur de 0,5 à 2 $\mu$m environ.

Ainsi que représenté à la figure 9a, le revêtement présente, suivant son épaisseur e', un gradient de concentration en volume de nitrure, carbure, borure métallique et d'or opposé ainsi que représenté à la figure 9b. Dans ce cas la zone de revêtement de concentration en nitrure carbure borure métallique la plus élevée se trouve au voisinage de la face du substrat revêtue ou de la couche intermédiaire 601 et la zone de revêment à concentration en or la plus élevée est disposée à la surface libre de revêtement, cette zone conférant au revêtement l'éclat de l'or. De manière générale cette zone a une épaisseur maximale de l'ordre de 0,1 $\mu$m sur laquelle le revêtement est constitué sensiblement par de l'or d'orfévrerie (or à 18 carats), l'adhérence de cette zone superficielle aux zones dures en nitrure métallique sous-jacentes, étant d'excellente qualité du fait de la décroissance progressive, selon l'épaisseur, de la concentration en volume en or et de la croissance progressive opposée en composé métallique, nitrure, borure, carbure métallique.

La figure 9b représente une variante de réalisation particulièrement intéressante du revêtement de composé d'or objet de l'invention. Dans ce cas, le revêtement comporte suivant son épaisseur e' une superposition de couches élémentaires constituées chacune par un mélange de nitrure, carbure, borure métallique et d'or en pourcentage volumique déterminé. A titre d'exemple non limitatif représenté à la figure 9b, le revêtement 61 comporte une couche superficielle 611 de

0,1 $\mu$m d'épaisseur constituée par de l'or à 18 carats, une couche intermédiaire 612 de 0,5 $\mu$m d'épaisseur constituée par un mélange comportant 60% d'or en volume et 40% de nitrure métallique et une couche de 1,5 $\mu$m d'épaisseur comportant en volume 30% d'or et 70% de nitrure métallique noté CM.

Le nitrure métallique peut être dans tous les cas soit un nitrure d'un métal du groupe 4A de la classification périodique des éléments tel que titane, zirconium, hafnium soit un mélange de ces nitrures, soit un mélange de ces nitrures et de carbure, borure de ces métaux et du tantale ou le mélange précité comportant en outre des carbonitrures de ces métaux.

La protection n'est pas limitée au dépôt d'un revêtement dur d'un composé d'or.

Par revêtement dur métallique il faut comprendre un revêtement obtenu par le procédé selon l'invention dans lequel la cible composite est constituée sensiblement par au moins un des métaux nobles du groupe or, or blanc, argent, rhodium, palladium, platine, iridium, osmium et d'au moins un des composés métalliques tels que nitrure, carbure, borure des métaux du groupe 4A de la classification périodique des éléments et du tantale.

La substitution de tout ou partie du volume d'or dans la cible composite par au moins l'un des métaux nobles précités permet notamment d'obtenir les teintes telles que la teinte or, le blanc de joaillerie, et les teintes intermédiaires.

Dans ce but le cermet pour la mise en oeuvre du procédé comporte en pourcentage volumique sensiblement identique au moins un des métaux nobles du groupe or, or blanc, argent, rhodium, palladium, platine, iridium, osmium et au moins un des composés métalliques tels que nitrure, carbure, borure des métaux du groupe 4A de la classification périodique des éléments et du tantale.

Le revêtement ainsi obtenu est essentiellement constitué d'au moins un des métaux nobles du groupe or, argent, rhodium, palladium, platine, iridium, osmium et d'au moins un des composés métalliques tels que nitrure, carbure, borure, des métaux du groupe 4A de la classification périodique des éléments et du tantale.

Le revêtement comporte suivant son épaisseur un gradient opposé de concentration en volume d'au moins un des métaux nobles du groupe précité et d'au moins un des composés métalliques tels que nitrure, carbure, borure des métaux du groupe 4A de la classification périodique des éléments et du tantale. Le gradient peut être constitué de couches élémentaires constituées chacune par un mélange d'au moins un des métaux nobles du groupe or, or blanc, argent, rhodium, palladium, platine, iridium, osmium et d'au moins un des composés métalliques tel que nitrure, carbure, borure des métaux du groupe 4A de la classification périodique des éléments et du tantale en concentrations volumiques respectives, déterminées.

**Revendications**

1. Procédé de dépôt d'un revêtement dur métallique sur un substrat massif par évaporation ou pulvérisation cathodique d'un cible constituée par un moins un métal noble du groupe de l'or, l'argent, le rhodium, le palladium, le platine, l'iridium et l'osmium et d'au moins un composé métallique constitué par un nitrure, carbure ou borure des métaux du groupe 4A de la classification périodique des éléments et du tantale, caractérisé en ce qu'au cours du dépôt on fait simultanément croître la concentration en volume de métal noble et décroître celle du composé métallique déposés selon des gradients opposés au moyen d'une cible comportant, suivant son épaisseur, des gradients de concentration en volume de métal noble et de composé métallique opposés, le dépôt étant réalisé sous atmosphère de gaz neutre ou réactive, sous une pression comprise entre $4 \times 10^{-4}$ et $3 \times 10^{-2}$ Torr.

2. Procédé selon la revendication 1, caractérisé en ce que la cible est formée par la superposition de couches élémentaires constituées chacune par un mélange homogène de poudre de métal noble et de composé métallique, la concentration en volume de chacun de ces composants étant croissante, respectivement décroissante, d'une couche à la couche suivante.

3. Procédé selon l'une des revendications précédentes, caractérisé en ce que la cible est un cermet.

4. Procédé de dépôt d'un revêtement du métallique sur un substrat massif par évaporation ou pulvérisation cathodique d'au moins un métal noble du groupe de l'or, l'argent, le rhodium, le palladium, le platine, l'irridium et l'osmium et d'au moins un composé métallique constitué par un nitrure, carbure ou borure des métaux du groupe 4A de la classification périodique des éléments et du tantale, caractérisé en ce qu'au cours du dépôt on fait simultanément croître la concentration en volume de métal noble et décroître celle du composé métallique déposés selon des gradients opposés, au moyen d'au moins deux cibles élémentaires constituées respectivement par le métal noble et le composé métallique, les cibles élémentaires étant soumises simultanément à l'évaporation ou la pulvérisation selon des vitesses d'évaporation ou de pulvérisation croissantes, respectivement décroissantes, au cours de dépôt, le dépôt étant réalisé sous atmosphère de gaz neutre ou réactive sous une pression comprise entre $4 \times 10^{-4}$ et $3 \times 10^{-2}$ Torr.

5. Procédé de dépôt d'un revêtement dur métallique sur un substrat massif par évaporation ou pulvérisation cathodique d'au moins un métal noble du groupe de l'or, l'argent, le rhodium, le palladium, le platine, l'iridium et l'osmium et d'au moins un composé métallique constitué par un nitrure, carbure ou borure des métaux du groupe 4A de la classification périodique des éléments et du tantale, caractérisé en ce qu'au cours du dépôt on fait simultanément croître la concentration en volume de métal noble et décroître celle du composé métallique déposés selon des gradients opposés, au moyen d'un moins deux cibles élémentaires de composition différente chacune étant constituée par un mélange homogène du métal noble et du composé métallique, en ce que le substrat est entraîné en rotation successivement devant chaque cible élémentaire, la vitesse d'évaporation ou de pulvérisation de chaque cible élémentaire étant modulée en fonction du mouvement du substrat de façon que la concentration en volume du métal noble et du composé métallique déposés croisse, respectivement décroisse, au cours du dépôt, et en ce que le dépôt est réalisé sous atmosphère de gaz neutre ou réactive sous une pression comprise entre $4 \times 10^{-4}$ et $3 \times 10^{-2}$ Torr.

6. Procédé selon l'une des revendications précédentes, caractérisé en ce que les concentrations en volume globale de la cible en métal noble et en composé métallique sont identiques.

7. Cermet convenant à la mise en oeuvre du procédé selon la revendication 3, caractérisé en ce qu'il est constitué par au moins un métal noble du groupe de l'or, l'argent, le rhodium, le palladium, le platine, l'iridium et l'osmium et au moins un composé métallique constitué par un nitrure, carbure ou borure des métaux du groupe 4A de la classification périodique des éléments et du tantale, les gradients de concentration en volume de métal noble et de composé métallique selon l'épaisseur du cermet étant opposés.

8. Cermet selon la revendication 7, caractérisé en ce qu'il est formé par la superposition des couches élémentaires constituées chacune par un mélange homogène de poudre de métal noble et de composé métallique, la concentration en volume de chacun de ces composants étant croissante, respectivement décroissante, d'un couche à la couche suivante.

9. Cermet selon la revendication 7, caractérisé en ce que les concentrations en volume globales du cermet en métal noble et en composé métallique sont identiques.

10. Pièce de joaillerie comportant sur un substrat massif un revêtement dur métallique constitué par le mélange d'un moins un métal noble du groupe de l'or, l'argent, le rhodium, le palladium, le platine, l'iridium et l'osmium et d'au moins un composé métallique constitué par un niture, carbure, ou borure des métaux du groupe 4A de la classification péridique des éléments et du tantale, caractérisé en ce que la concentration en volume du métal noble dans le revêtement croît en direction de la surface de celui-ci, tandis que celle du composé métallique décroît, selon des gradients opposés.

11. Pièce de joaillerie selon la revendication 10, caractérisée en ce que le revêtement métallique est constitué par la superposition de couches élémentaires présentant chacune une concentration en volume homogène de métal noble et du composé métallique.

12. Pièce de joaillerie selon la revendication 10 ou 11, caractérisée en ce que le revêtement métallique présente des concentrations en volume globales en métal noble et en composé métallique identiques.

13. Pièce de joaillerie selon l'une des revendications 10 à 12, caractérisé en ce qu'elle comporte entre le substrat massif et le revêtement une couche intermédiaire.

14. Pièce de joaillerie selon la revendication 13, caractérisé en ce que la couche intermédiaire est en acier inoxydable.

## Patentansprüche

1. Verfahren zum Aufbringen einer hartmetallischen Beschichtung auf einem massiven Substrat durch Verdampfung oder Kathodenzerstäubung eines Zieles bestehend aus mindestens einem Edelmetall der Gruppe Gold, Silber, Rhodium, Palladium, Platin, Iridium und Osmium und mindestens einer Metallverbindung, bestehend aus einem Nitrit, Karbid oder Borid der Metalle der Gruppe 4A des Periodensystems der Elemente und Tantal, dadurch gekennzeichnet, daß man während des Aufbringens gleichzeitig die Volumenkonzentration des aufgebrachten Edelmetalls ansteigen läßt und diejenige der aufgebrachten Metallverbindung abfallen läßt, gemäß entgegengesetzten Radienten, vermittels eines Zieles, das in Richtung seiner Dicke Volumenkonzentrationsgradienten an Edelmetall und Metallverbindung, die einander entgegengesetzt sind, umfaßt, wobei das Aufbringen in einer Atmosphäre neutralen oder reaktiven Gases unter einem Druck zwischen $4 \times 10^{-4}$ und $3 \times 10^{-2}$ Torr. realisiert wird.

2. Verfahren nach Anspruch 1, dadurch gekennzeichnet, daß das Ziel durch Überlagerung von Elementarschichten gebildet wird, jeweils bestehend aus einem homogenen Gemisch von Pulver aus Edelmetall und Metallverbindung, wobei die Volumenkonzentration jeder dieser Komponenten ansteigend bzw. abfallend ist von einer Schicht zur folgenden.

3. Verfahren nach einem der vorangehenden Ansprüche, dadurch gekennzeichnet, daß das Ziel ein Cermet ist.

4. Verfahren zum Aufbringen einer hartmetallischen Beschichtung auf einem massiven Substrat durch Verdampfen oder Kathodenzerstäuben mindestens eines Edelmetalls der Gruppe Gold, Silber, Rhodium, Palladium, Platin, Iridium und Osmium und mindestens einer Metallverbindung gebildet von einem Nitrit, Karbid oder Borid der Metalle der Gruppe 4A des Periodensystems der Elemente und Tantal, dadurch gekennzeichnet, daß man während des Aufbringens gleichzeitig die Volumenkonzentration des aufgebrachten Edelmetalls ansteigen und diejenige der Metallverbindung gemäß entgegengesetzten Gradienten abfallen läßt, vermittels mindestens zweier Elementarziele, jeweils gebildet aus dem Edelmetall und der Metallverbindung, welche Elementarziele gleichzeitig verdampft oder zerstäubt werden, entsprechend Verdampfung- oder Zerstäubungsgeschwindigkeiten, die während des Aufbringens ansteigen bzw. abfallen, wobei das Aufbringen unter einer Atmosphäre von neutralem oder reaktivem Gas unter einem Druck zwischen $4 \times 10^{-4}$ und $3 \times 10^{-2}$ Torr. realisiert wird.

5. Verfahren zum Aufbringen einer hartmetallischen Beschichtung auf einem massiven Substrat durch Verdampfen oder Kathodenzerstäuben mindestens eines Edelmetalls der Gruppe Gold, Silber, Rhodium, Palladium, Platin, Iridium und Osmium und mindestens einer Metallverbindung gebildet von einem Nitrit, Karbid oder Borid der Metalle der Gruppe 4A des Periodensystems der Elemente und Tantal, dadurch gekennzeichnet, daß man während des Aufbringens die Volumenkonzentration des aufgebrachten Edelmetalls ansteigen und diejenige der Metallverbindung abfallen läßt gemäß entgegengesetzten Gradienten, vermittels mindestens zweier Elementarziele unterschiedlicher Zusammensetzung, jeweils bestehend aus einem homogenen Gemisch aus Edelmetall und Metallverbindung, daß das Substrat zur Drehung angetrieben wird nacheinander vor jedem Elementarziel, wobei die Verdampfungs- oder Zerstäubungsgeschwindigkeit jedes Elementarziels moduliert wird in Funktion der Bewegung des Substrats derart, daß die Volumenkonzentration des Edelmetalls und der Metallverbindung ansteigend bzw. abfallend abgelagert wird während der Beschichtung und daß die Beschichtung in einer Atmosphäre von neutralem Gas oder reaktivem Gas unter einem Druck zwischen $4 \times 10^{-4}$ und $3 \times 10^{-2}$ Torr. realisiert wird.

6. Verfahren nach einem der vorangehenden Ansprüche, dadurch gekennzeichnet, daß die globalen Volumenkonzentrationen des Zieles aus Edelmetall und aus Metallverbindung identisch sind.

7. Cermet für die Durchführung des Verfahrens gemäß Anspruch 3, dadurch gekennzeichnet, daß es aus mindestens einem Edelmetall der Gruppe Gold, Silber, Rhodium, Palladium, Platin, Iridium und Osmium und mindestens einer Metallverbindung aus Nitrit, Karbid oder Borid der Metalle der Gruppe 4A des Periodensystems der Elemente und Tantal besteht, wobei die Volumenkonzentrationsgradienten des Edelmetalls und der Metallverbindung in Richtung der Cermet-Dicke einander entgegengesetzt sind.

8. Cermet nach Anspruch 7, dadurch gekennzeichnet, daß es durch Überlagerung von Elementarschichten gebildet ist, jeweils bestehend aus einem homogenen Gemisch aus Pulvervon Edelmetall bzw. Metallverbindung, wobei die Volumenkonzentration jeder dieser Komponenten von einer Schicht zur folgenden anstiegend bzw. abfallend ist.

9. Cermet nach Anspruch 7, dadurch gekennzeichnet, daß die Gesamtvolumenkonzentrationen des Cermets an Edelmetall und an Metallverbindung identisch sind.

10. Schmuckstück, umfassend auf einem massiven Substrat eine hartmetallische Beschichtung, gebildet aus einem Gemisch von mindestens einem Edelmetall der Gruppe Gold, Silber, Rhodium, Palladium, Platin, Irridium und Osmium und mindestens einer Metallverbindung, gebildet aus einen Nitrit, Karbid oder Borid der Metalle der Gruppe 4A des Periodensystems der Elemente und von Tantal, dadurch gekennzeichnet, daß die Volumenkonzentration des Edelmetalls in der Beschichtung in Richtung von deren Oberfläche ansteigt, während diejenige der Metallverbindung abfällt gemäß entgegengesetzten Gradienten.

11. Schmuckstück nach Anspruch 10, dadurch gekennzeichnet, daß die metallische Beschichtung aus der Überlagerung von Elementarschichten besteht, welche jeweils eine homogene Volumenkonzentration an Edelmetall und an Metallverbindung aufweisen.

12. Schmuckstück nach Anspruch 10 oder 11, dadurch gekennzeichnet, daß die metallische Beschichtung insgesamt identische Volumenkonzentrationen an Edelmetall und an Metallverbindung aufweist.

13. Schmuckstück nach einem der Ansprüche 10 bis 12, dadurch gekennzeichnet, daß es zwischen dem massiven Substrat und der Beschichtung eine Zwischenschicht aufweist.

14. Schmuckstück nach Anspruch 13, dadurch gekennzeichnet, daß die Zwischenschicht aus Edelstahl besteht.

**Claims**

1. A method of depositing a hard metallic coating on a solid substrate by evaporation or by cathodic pulverization of a target formed of at least one noble metal from the gold, silver, rhodium, palladium, platinum, iridium and osmium group and of at least one metallic compound consisting of a nitride, carbide or boride of the metals in group 4A of the periodic classification of the elements and of tantalum, characterized in that during deposition the concentration in volume of the deposited noble metal and that of the deposited metallic compound are simultaneously made to increase and decrease respectively according to opposite gradients by means of a target having, thicknesswise, opposite gradients of concentration in volume of said noble metal and of said metallic compound, the deposition being carried out in a neutral or reactive gaseous atmosphere at a pressure ranging from $4 \times 10^{-4}$ to $3 \times 10^{-2}$ Torr.

2. A method according to claim 1, characterized in that the target is formed by superposing elementary layers each consisting of a homogeneous mixture of noble metal powder and of metallic compound powder, the concentration in volume of these components increasing and decreasing respectively from one layer to the next.

3. A method according to any one of the preceding claims, characterized in that the target is a cermet.

4. A method of depositing a hard metallic coating on a solid substrate by evaporation or by cathodic pulverization of at least one noble metal from the gold, silver, rhodium, palladium, platinum, iridium and osmium group and of at least one metallic compound consisting of a nitride, carbide or boride of the metals in group 4A of the periodic classification of the elements and of tantalum, characterized in that during deposition the concentration in volume of the deposited noble metal and that of the deposited metallic compound are simultaneously made to increase and decrease respectively according to opposite gradients by means of at least two elementary targets respectively consisting of said noble metal and of said metallic compound, the elementary targets being simultaneously subjected to evaporation or pulverization according to respectively increasing and decreasing speeds of evaporation or pulverization during deposition, the deposition being carried out in a neutral or reactive gaseous atmosphere at a pressure ranging from $4 \times 10^{-4}$ to $3 \times 10^{-2}$ Torr.

5. A method of depositing a hard metallic coating on a solid substrate by evaporation or by cathodic pulverization of at least one noble metal from the gold, silver, rhodium, palladium, platinum, iridium and osmium group and of at least one metallic compound consisting of a nitrite, carbide or boride of the metals in group 4A of the periodic classification of the elements and of tantalum, characterized in that during deposition the concentration in volume of the deposited noble metal and that of the deposited metallic compound are simultaneously made to increase and decrease respectively according to opposite gradients by means of at least two elementary targets of different composition each consisting of a homogeneous mixture of said noble metal and of said metallic compound, in that the substrate is driven in rotation successively before each elementary target, the speed at which each elementary target is evaporated or pulverized being modulated in dependence on the motion of the substrate such that the concentration in volume of the deposited noble metal and of the deposited metal compound respectively increases and decreases during deposition, and in that the deposition is carried out in a neutral or reactive gaseous atmosphere at a pressure ranging from $4 \times 10^{-4}$ to $3 \times 10^{-2}$ Torr.

6. A method according to any one of the preceding claims, characterized in that the overall volume concentrations of said noble metal and of said metallic compound in the target are identical.

7. A cermet suitable for carrying out the method according to claim 3, characterized in that it is made up of at least one noble metal from the gold, silver, rhodium, palladium, platinum, iridium and osmium group and of at least one metallic compound consisting of a nitride, carbide or boride of the metals in group 4A of the periodic classification of the elements and of tantalum, the volume concentration gradients of said noble metal and of said metallic compound, thicknesswise of the cermet, being opposite.

8. A cermet according to claim 7, characterized in that it is formed by superposing elementary layers each consisting of a mixture of noble metal and of metallic compound, the concentration in volume of these components increasing and decreasing respectively from one layer to the next.

9. A cermet according to claim 7, characterized in that the overall volume concentrations of said noble metal and of said metallic compound in the cermet are identical.

10. A piece of jewellery comprising, on a solid substrate, a hard metallic coating made up of a mixture of at least one noble metal from the gold, silver, rhodium, palladium, platinum, iridium and osmium group and of at least one metallic compound consisting of a nitride, carbide or boride of the metals in group 4A of the periodic classification of the elements and of tantalum, characterized in that the concentration in volume of said noble metal in the coating increases towards the surface thereof whilst that of said metallic compound decreases, according to opposite gradients.

11. A piece of jewellery according to claim 10, characterized in that the metallic coating is formed by superposing elementary layers each having a homogeneous concentration in volume of said noble metal and of said metallic compound.

12. A piece of jewellery according to claim 10 or 11, characterized in that the metallic coating has identical overall concentrations in volume of said noble metal and of said metallic compound.

13. A piece of jewellery according to any one of claims 10 to 12, characterized in that it comprises between the solid substrate and the coating, an intermediate layer.

14. A piece of jewellery according to claim 13, characterized in that the intermediate layer is of stainless steel.

Fig. 1

Fig. 2

1

Fig. 3

Fig. 4a

Fig. 4b

0 038 294

Fig. 5a

Fig. 5b

Fig. 6a

Fig. 6b

Fig. 7a

Fig. 7b

Fig. 8a

Fig. 8b

Fig. 9a

Fig. 9b